# EUROPEAN PATENT APPLICATION

(11) **EP 4 287 790 A1**
(43) Date of publication of application: **06.12.2023**
(21) Application number: 23173079.7
(22) Date of filing: 12.05.2023
(51) Int. Cl.: H05K 1/18, H05K 3/00, H05K 3/34

(54) **ELECTRONIC DEVICE AND MANUFACTURING METHOD THEREOF**

(30) Priority: 01.06.2022 US 202263347575 P; 20.02.2023 CN 202310135451
(71) Applicant: Innolux Corporation, Jhunan Town, Miaoli County 35053 (TW)
(72) Inventor: CHI, Jen-Hai, 35053 Jhunan Town, Miaoli County (TW); TSENG, Chia-Ping, 35053 Jhunan Town, Miaoli County (TW)
(74) Representative: Becker, Eberhard

(57) **Abstract**

The disclosure provides an electronic device and a manufacturing method thereof. The electronic device includes a flexible substrate, an adhesive layer, a metal layer, a driving unit, and a modulating unit. The adhesive layer is disposed on the flexible substrate. The metal layer is disposed on the adhesive layer. The driving unit is disposed on the adhesive layer. The modulating unit is disposed on the adhesive layer. The manufacturing method of the electronic device includes the following steps: providing a carrier substrate; forming a first metal layer on the carrier substrate; providing a flexible substrate, and combining the flexible substrate and the carrier substrate; removing the carrier substrate; and providing a modulating unit, and disposing the modulating unit on the flexible substrate. The electronic device and the manufacturing method thereof of the embodiments of the disclosure may make the electronic device having the modulating unit applicable to a non-planar structure.

## Description

### BACKGROUND

### Technical Field

The disclosure relates to an electronic device and a manufacturing method thereof, in particular to an electronic device having a modulating unit that may be applied to a non-planar structure and a manufacturing method thereof.

### Description of Related Art

Electronic devices or tiling electronic devices have been widely used in different fields such as communication, display, automotive, or aviation. With the vigorous development of electronic devices, the electronic devices are developed to be thin and lightweight, and therefore, higher reliability or quality requirements are desired for the electronic devices.

### SUMMARY

The disclosure provides an electronic device and a manufacturing method thereof that make the electronic device having a modulating unit applicable to a non-planar structure, wherein the non-planar structure includes windows, buildings, utility poles, car roofs, etc., but the disclosure is not limited thereto.

According to an embodiment of the disclosure, an electronic device includes a flexible substrate, an adhesive layer, a metal layer, a driving unit, and a modulating unit. The adhesive layer is disposed on the flexible substrate. The metal layer is disposed on the adhesive layer. The driving unit is disposed on the adhesive layer. The modulating unit is disposed on the adhesive layer.

According to an embodiment of the disclosure, a manufacturing method of an electronic device includes the following steps: providing a carrier substrate; forming a first metal layer on the carrier substrate; providing a flexible substrate, and combining the flexible substrate and the carrier substrate; removing the carrier substrate; and providing a modulating unit, and disposing the modulating unit on the flexible substrate.

### BRIEF DESCRIPTION OF THE DRAWINGS

The accompanying drawings are included to further understand the disclosure, and the drawings are incorporated in the specification and constitute a part of the specification. The drawings illustrate embodiments of the disclosure and, together with the description, serve to explain principles of the disclosure.
FIG. 1A to FIG. 1D are schematic cross-sectional views of a manufacturing method of an electronic device of the first embodiment of the disclosure.
FIG. 2A to FIG. 2E are schematic cross-sectional views of a manufacturing method of an electronic device of the second embodiment of the disclosure.
FIG. 3A to FIG. 3E are schematic cross-sectional views of a manufacturing method of an electronic device of the third embodiment of the disclosure.

### DESCRIPTION OF THE EMBODIMENTS

The disclosure may be understood by referring to the following detailed description in conjunction with the accompanying drawings. It should be noted that in order to facilitate understanding to the reader and to simplify the drawings, the multiple drawings in the disclosure depict a part of an electronic device, and certain elements in the drawings are not drawn to actual scale. In addition, the quantity and size of each element in the figures are for illustration, and are not intended to limit the scope of the disclosure.

In the following description and claims, words such as "containing" and "including" are open-ended words, so they should be interpreted as meaning "containing but not limited to..."

It should be understood that, when an element or film is referred to as being "on" or "connected to" another element or film, it may be directly on or directly connected to this other element or layer, or there may be an intervening element or layer in between (indirect case). In contrast, when an element is referred to as being "directly on" or "directly connected to" another element or layer, there are no intervening elements or layers present.

Although the terms "first", "second", "third"...may be used to describe various constituent elements, the constituent elements are not limited to these terms. These terms are used to distinguish a single constituent element from other constituent elements in the specification. The same terms may be not used in the claims, but are replaced by first, second, third...in the order in which elements are declared in the claims. Therefore, in the following description, a first constituent element may be a second constituent element in the claims.

In the text, the terms "about", "approximately", "substantially", and "essentially" usually mean within 10%, or within 5%, or within 3%, or within 2%, or within 1%, or within 0.5% of a given value or range. The quantities given here are approximate quantities, that is, in the absence of specific descriptions of "about", "approximately", "substantially", "essentially", the meaning of "about", "approximately", "substantially", "essentially" may still be implied.

In some embodiments of the disclosure, terms related to joining, connecting, such as "connecting", "interconnecting", etc., unless otherwise specified, may mean that two structures are in direct contact, or it may also mean that the two structures are not in direct contact, and there are other structures disposed between the two structures. Moreover, the terms of bonding and connecting may also include the case where both structures are movable or both structures are fixed. In addition, the term "coupled" includes any direct and indirect electrical connection means.

In some embodiments of the disclosure, optical microscopy (OM), scanning electron microscope (SEM), film thickness profiler (α-step), ellipsometer, or other suitable methods may be used to measure the area, width, thickness, or height of each element, or the distance or spacing between the elements. Specifically, according to some embodiments, a scanning electron microscope may be used to obtain a cross-sectional structure image including the elements to be measured, and measure the area, width, thickness, or height of each element, or the distance or spacing between the elements.

An electronic device of disclosure may include a display equipment, an antenna device, a sensing device, or a tiling device, but the disclosure is not limited thereto. The electronic device may be a bendable, foldable, rollable, slidable, stretchable or flexible electronic device. The electronic device may, for example, include a liquid-crystal light-emitting diode; the light-emitting diode may include, for example, an organic light-emitting diode (OLEDs), a sub-millimeter light-emitting diode (mini LED), a micro light-emitting diode (micro LED), or a quantum dot light-emitting diode (quantum dot, QD, for example, QLED or QDLED), fluorescence, phosphor, or other suitable materials, and the materials thereof may be arbitrarily arranged and combined, but the disclosure is not limited thereto. The display equipment may be a non-self-illuminating display equipment or a self-illuminating display equipment. The antenna device may include, for example, a frequency selective surface (FSS), a radio frequency filter (RF-Filter), a polarizer, a resonator, or an antenna, etc. The antenna device may be, for example, a liquid-crystal antenna, but the disclosure is not limited thereto. The tiling device may be, for example, a display tiling device or an antenna tiling device, but the disclosure is not limited thereto. It should be noted that the electronic device may be any combination of the foregoing, but the disclosure is not limited thereto. In addition, the shape of the electronic device may be rectangular, circular, polygonal, with curved edges, or other suitable shapes. The electronic device may have a peripheral system such as a drive system, a control system, a light source system, a shelf system, etc. to support the display equipment, the antenna device, or the tiling device. Hereinafter, an electronic device is used to illustrate the content of the disclosure, but the disclosure is not limited thereto.

It should be noted that in the following embodiments, the features in several different embodiments may be replaced, recombined, and mixed to complete other embodiments without departing from the spirit of the disclosure. As long as the features between the embodiments do not violate the spirit of the disclosure or conflict with each other, they may be mixed and used arbitrarily.

Hereinafter, reference will be made in detail to exemplary embodiments of the disclosure, and examples of the exemplary embodiments are illustrated in the figures. Wherever possible, the same reference numerals are used in the figures and the descriptions to refer to the same or similar portions.

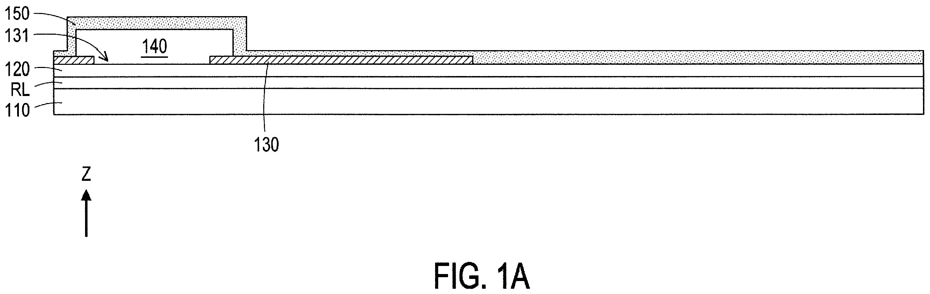

FIG. 1A to FIG. 1D are schematic cross-sectional views of a manufacturing method of an electronic device of the first embodiment of the disclosure. In particular, an electronic device 100 of the present embodiment has flexible or curved characteristics, and the manufacturing method of the electronic device 100 of the present embodiment may include the following steps:

First, please refer to FIG. 1A, a carrier substrate 110 is provided, a release layer RL is formed on the carrier substrate 110, and a protective layer 120 is formed on the carrier substrate 110. In particular, the release layer RL is disposed between the protective layer 120 and the carrier substrate 110, and the release layer RL may be removed together with the carrier substrate 110 in subsequent steps. In the present embodiment, the carrier substrate 110 may include a rigid substrate, a flexible substrate, or a combination of the above. For example, the material of the carrier substrate 110 may include glass, quartz, sapphire, ceramics, polycarbonate (PC), polyimide (PI), polyethylene terephthalate (PET), other suitable substrate materials, or a combination of the above, but the disclosure is not limited thereto. The material of the release layer RL may include, but not limited to, an adhesive material losing adhesive properties when heated or irradiated by ultraviolet light. The protective layer 120 may be a single-layer structure or a multi-layer structure, and may include, for example, an organic material, an inorganic material, or a combination thereof, but the disclosure is not limited thereto. In some embodiments, the release layer may also not be disposed between the protective layer and the carrier substrate according to requirements.

Next, please refer further to FIG. 1A. A metal layer 130 is formed on the carrier substrate 110, a driving unit 140 is disposed on the carrier substrate 110, and an insulating layer 150 is formed on the carrier substrate 110. In particular, the metal layer 130 is disposed on the protective layer 120, and the metal layer 130 has an opening 131 that may expose a portion of the protective layer 120. The driving unit 140 is disposed on the metal layer 130 and in the opening 131 of the metal layer 130, and the driving unit 140 may be electrically connected to the metal layer 130. In the present embodiment, the driving unit 140 may include a transistor (thin-film transistor, TFT), an integrated circuit (IC), or a combination thereof, but the disclosure is not limited thereto. In the present embodiment, the method of disposing the driving unit 140 on the carrier substrate 110 may be, for example, manufacturing the driving unit 140 using a thin film photolithography process on the carrier substrate 110, but the disclosure is not limited thereto. In some embodiments, the manufactured driving unit 140 may also be bonded on the carrier substrate 110. The insulating layer 150 is disposed on the driving unit 140, and the insulating layer 150 may cover the driving unit 140, the metal layer 130, and the protective layer 120. The insulating layer 150 may be a single-layer structure or a multi-layer structure, and may include, for example, an organic material, an inorganic material, or a combination thereof, but the disclosure is not limited thereto.

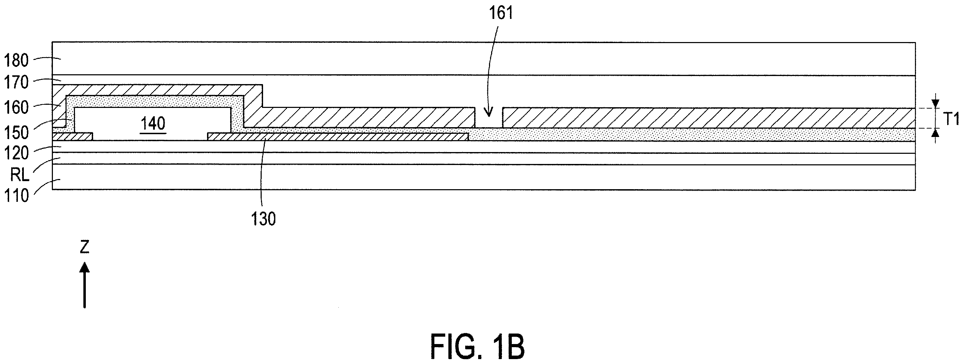

Then, referring to FIG. 1B, after the driving unit 140 is disposed, a metal layer 160 is formed on the carrier substrate 110. In particular, the metal layer 160 is disposed on the insulating layer 150 such that the insulating layer 150 is located between the metal layer 160 and the driving unit 140. The metal layer 160 includes an opening 161, and the opening 161 may expose a portion of the insulating layer 150. In the present embodiment, the material of the metal layer 160 may include aluminum, molybdenum, copper, silver, other suitable metal materials, or a combination thereof, but the disclosure is not limited thereto. In the present embodiment, a thickness T1 of the metal layer 160 may be greater than 0.5 micrometers (*µ*m) (i.e., T>0.5 *µ*m), but the disclosure is not limited thereto. In particular, the thickness T1 is, for example, the thickness of the metal layer 160 measured along the normal direction of the carrier substrate 110 or the normal direction of the electronic device 100 (i.e., the direction Z). When the thickness T1 of the metal layer 160 is less than 0.5 micrometers, the conductivity of the metal layer 160 decreases, the impedance of the metal layer 160 increases, a skin effect is generated on a high-frequency signal resulting in signal loss, or the heat dissipation effect of the electronic device 100 is deteriorated.

Next, referring further to FIG. 1B, an adhesive layer 170 is formed on the carrier substrate 110, a flexible substrate 180 is provided, and the flexible substrate 180 and the carrier substrate 110 are combined. In particular, the adhesive layer 170 is disposed on the metal layer 160 and in the opening 161 of the metal layer 160, the flexible substrate 180 is disposed on the adhesive layer 170, and the flexible substrate 180 may be combined with the carrier substrate 110 via the adhesive layer 170. In the present embodiment, the material of the flexible substrate 180 may include polycarbonate, polyimide, polyethylene terephthalate, other suitable flexible substrate materials, or a combination thereof, but the disclosure is not limited thereto.

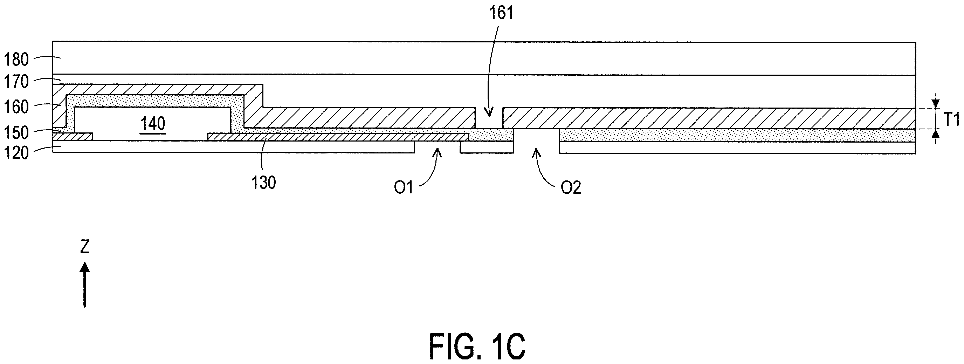

Then, referring to FIG. 1C, the carrier substrate 110 is removed, and a first opening O1 and a second opening O2 are formed. In the present embodiment, for example, the release layer RL and the carrier substrate 110 are removed by means of laser lift-off, so as to expose the protective layer 120. In the present embodiment, the protective layer 120 and the insulating layer 150 are drilled, for example, using laser drilling to form the first opening O1 and the second opening O2. In particular, the first opening O1 may expose the metal layer 130, and the second opening O2 may expose the metal layer 160. In some embodiments, the first opening O1 and/or the second opening O2 may be formed by etching process, but the disclosure is not limited thereto.

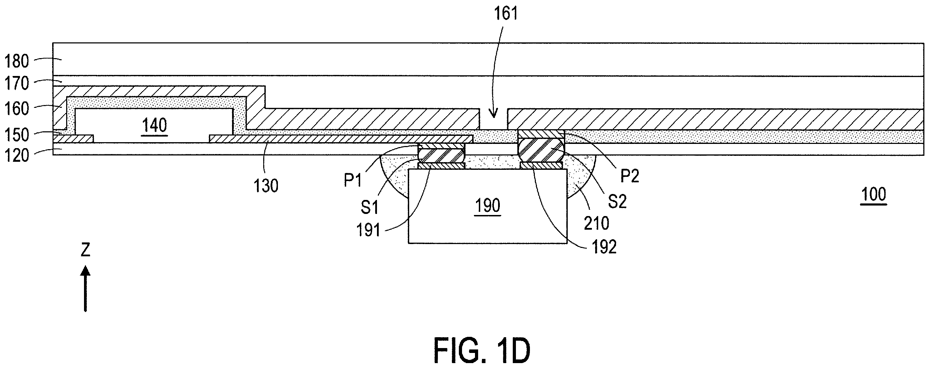

Then, referring to FIG. 1D, a conductive pad P1 and a conductive pad P2 are respectively formed in the first opening O1 and the second opening O2. In particular, the conductive pad P1 may be electrically connected to the metal layer 130, and the conductive pad P2 may be electrically connected to the metal layer 160. In the present embodiment, the material of the conductive pad P1 and the conductive pad P2 may include, but not limited to, electroless nickel immersion gold (ENIG), other suitable conductive materials, or a combination thereof, but the disclosure is not limited thereto.

Next, please refer further to FIG. 1D, a modulating unit 190 is provided and the modulating unit 190 is disposed on the flexible substrate 180. In particular, the modulating unit 190 may be disposed corresponding to the opening 161 of the metal layer 160, and the modulating unit 190 may be overlapped with the opening 161 of the metal layer 160 in the normal direction (i.e., the direction Z) of the electronic device 100. The modulating unit 190 may be connected to the conductive pad P1 and the conductive pad P2 via a solder pad S1 and a solder pad S2 respectively. The modulating unit 190 includes a first contact pad 191 and a second contact pad 192. The first contact pad 191 may be electrically connected to the driving unit 140 via the solder pad S1, the conductive pad P1, and the metal layer 130, and the second contact pad 192 may be electrically connected to the metal layer 160 via the solder pad S2 and the conductive pad P2.

In the present embodiment, the method of disposing the modulating unit 190 on the flexible substrate 180 may be, for example, bonding the manufactured modulating unit 190 on the flexible substrate 180, but the disclosure is not limited thereto. In some embodiments, the modulating unit 190 may also be manufactured on the flexible substrate 180 using a thin film photolithography process.

In the present embodiment, the modulating unit 190 may be used to modulate at least one of phase, amplitude, and frequency, but the disclosure is not limited thereto. For example, the modulating unit 190 may be used to modulate electromagnetic waves. In the present embodiment, the modulating unit 190 may include an integrated circuit, a transistor, a silicon-controlled rectifier, a valve, a TFT, a capacitor, an inductor, a variable capacitor, a filter, a resistor, a diode, a light-emitting diode, a micro electro mechanical system (MEMS), a liquid-crystal chip, a connector, an interposer, a redistribution layer (RDL) element, or a combination thereof, but the disclosure is not limited thereto.

Next, referring further to FIG. 1D, an underfill 210 is formed between the modulating unit 190 and the protective layer 120, so that the underfill 210 may cover and protect the solder pad S1, the solder pad S2, the first contact pad 191, and the second contact pad 192. In some embodiments, the electronic device 100 may also further be optionally molded. So far, the manufacture of the electronic device 100 of the present embodiment is substantially completed.

In the present embodiment, since the protective layer 120, the insulating layer 150, the metal layer 160, and the flexible substrate 180 respectively have different coefficients of thermal expansion (CTE) and are easily warped during a high-temperature process (such as the process of manufacturing the driving unit 140). The manufacturing method of the electronic device 100 of the present embodiment may alleviate the issue of warpage by performing the step of disposing the driving unit 140 first, and then performing the steps of forming the insulating layer 150, forming the metal layer 160, and disposing the flexible substrate 180.

Based on the above, it may be seen that the electronic device 100 of the present embodiment may include the flexible substrate 180, the adhesive layer 170, the metal layer 160, the driving unit 140, and the modulating unit 190. In particular, the adhesive layer 170 is disposed on the flexible substrate 180. The metal layer 160 is disposed on the adhesive layer 170. The driving unit 140 is disposed on the adhesive layer 170. The modulating unit 190 is disposed on the adhesive layer 170.

Other embodiments are listed below for description. It must be noted here that the following embodiments adopt the reference numerals and part of the content of the above embodiments, wherein the same reference numerals are used to represent the same or similar elements, and the description of the same technical content is omitted. For the description of the omitted parts, reference may be made to the above embodiments, which is not repeated in the following embodiments.

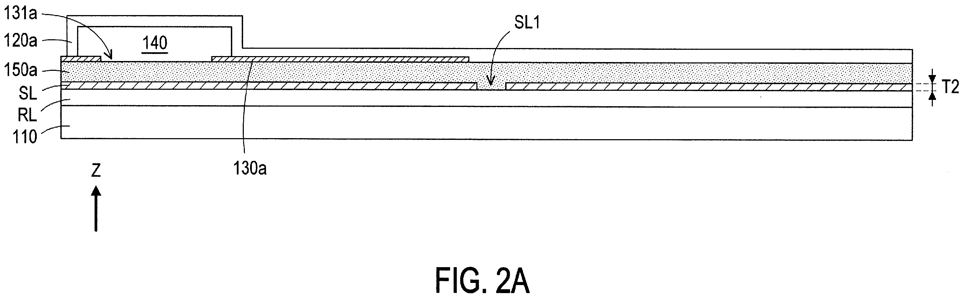

FIG. 2A to FIG. 2E are schematic cross-sectional views of a manufacturing method of an electronic device of the second embodiment of the disclosure. The second embodiment shown in FIG. 2A to FIG. 2E is similar to the first embodiment shown in FIG. 1A to FIG. 1D. Therefore, the same elements are denoted by the same reference numerals, and the details thereof are not repeated. In particular, an electronic device 100a of the present embodiment has flexible or curved characteristics, and the manufacturing method of the electronic device 100a of the present embodiment may include the following steps:

First, please refer to FIG. 2A, the carrier substrate 110 is provided, the release layer RL is formed on the carrier substrate 110, and the seed layer SL is formed on the release layer RL. In particular, the release layer RL is disposed between the seed layer SL and the carrier substrate 110, and the release layer RL may be removed together with the carrier substrate 110 in a subsequent step. In some embodiments, the release layer may also not be provided between the seed layer and the carrier substrate according to requirements. In the present embodiment, the seed layer SL includes an opening SL1, and the opening SL1 may expose a portion of the release layer RL. A thickness T2 of the seed layer SL may be, for example, less than 0.5 *µ*m, but the disclosure is not limited thereto. In particular, the thickness T2 is, for example, the thickness of the seed layer SL measured along the normal direction of the carrier substrate 110 or the normal direction of the electronic device 100a (i.e., the direction Z). In the present embodiment, the material of the seed layer SL may include titanium, copper, other suitable metal materials, or a combination thereof.

Next, please refer further to FIG. 2A. An insulating layer 150a is formed on the carrier substrate 110, the metal layer 130a is formed on the carrier substrate 110, the driving unit 140 is disposed on the carrier substrate 110, and a protective layer 120a is formed on the carrier substrate 110. In particular, the insulating layer 150a is disposed on the seed layer SL and in the opening SL1 of the seed layer SL. The metal layer 130a is disposed on the insulating layer 150a, and the metal layer 130a has an opening 131a that may expose a portion of the insulating layer 150a. The driving unit 140 is disposed on the metal layer 130a and in the opening 131a of the metal layer 130a, and the driving unit 140 may be electrically connected to the metal layer 130a. The protective layer 120a is disposed on the driving unit 140, and the protective layer 120a may cover the driving unit 140, the metal layer 130a, and the insulating layer 150a.

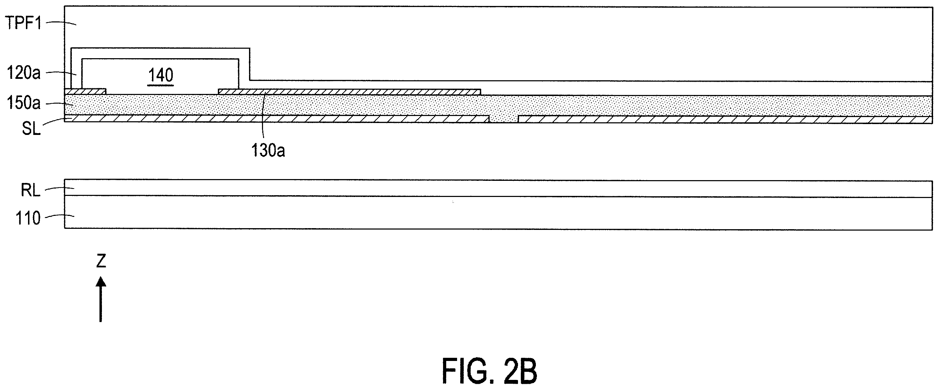

Then, referring to FIG. 2B, a temporary protective film TPF1 is formed on the carrier substrate 110, and the release layer RL and the carrier substrate 110 are removed to expose the seed layer SL. In particular, the temporary film TPF1 is disposed on the protective layer 120a, so that the structure from which the release layer RL and the carrier substrate 110 are removed is not warped, thereby facilitating subsequent processing. In the present embodiment, the temporary protective film TPF1 is, for example, a base material containing a weak adhesive layer. For example, the material of the base material may include polyvinyl chloride (PVC), polyimide, or polyethylene terephthalate, but the disclosure is not limited thereto.

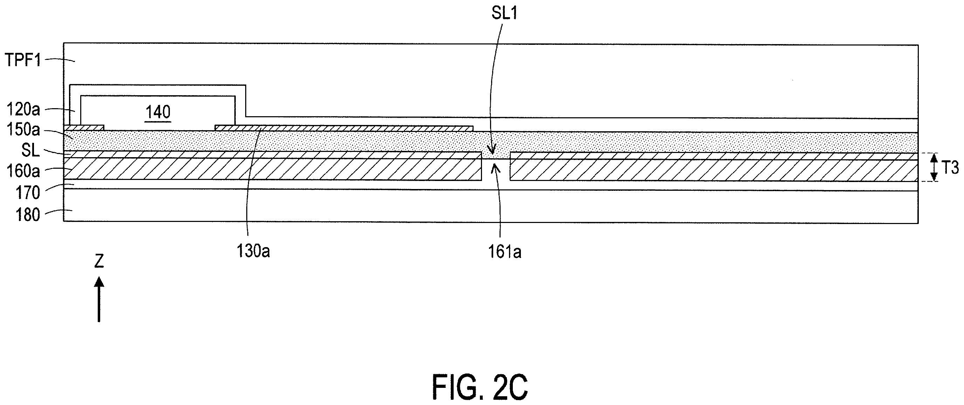

Next, referring to FIG. 2C, after the driving unit 140 is disposed, a metal layer 160a is formed on the temporary protective film TPF1, the adhesive layer 170 is formed on the temporary protective film TPF1, the flexible substrate 180 is provided, and the flexible substrate 180 and the temporary protective film TPF1 are combined. In particular, the metal layer 160a is disposed on the seed layer SL, so that the insulating layer 150a is located between the driving unit 140 and the metal layer 160a. The metal layer 160a includes an opening 161a, the opening 161a may expose a portion of the insulating layer 150a, and the opening 161a may overlap the opening SL1 of the seed layer SL in the normal direction (i.e., direction Z) of the electronic device 100a. The sum thickness of the metal layer 160a and the seed layer SL is a thickness T3, and the thickness T3 may be, for example, greater than 0.5 *µ*m, but the disclosure is not limited thereto. In particular, the thickness T3 is, for example, the thickness measured along the normal direction of the flexible substrate 180 or the normal direction of the electronic device 100 a (i.e., the direction Z) of the metal layer 160a and the seed layer SL. When the thickness T3 is greater than 0.5 *µ*m, the skin effect of a high-frequency signal may be reduced to reduce the loss of the signal. The adhesive layer 170 is disposed on the metal layer 160a and in the opening 161a of the metal layer 160a, the flexible substrate 180 is disposed on the adhesive layer 170, and the flexible substrate 180 may be combined with the temporary protective film TPF1 via the adhesive layer 170.

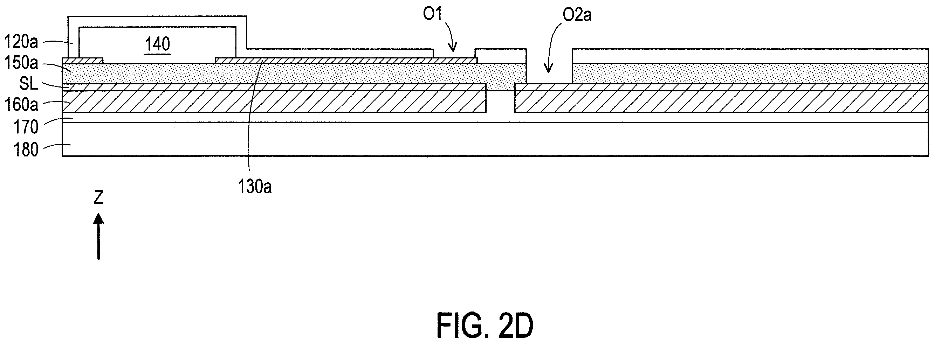

Then, referring to FIG. 2D, the temporary protective film TPF1 is removed, and the first opening O1 and a second opening O2a are formed. In the present embodiment, for example, the temporary protective film TPF1 is removed by manual tearing or mechanical tearing to expose the protective layer 120a. In the present embodiment, the protective layer 120a and the insulating layer 150a are drilled, for example, using laser drilling to form the first opening O1 and the second opening O2a. In particular, the first opening O1 may expose the metal layer 130a, and the second opening O2a may expose the seed layer SL. In some embodiments, the first opening O1 and/or the second opening O2a may be formed by etching process, but the disclosure is not limited thereto.

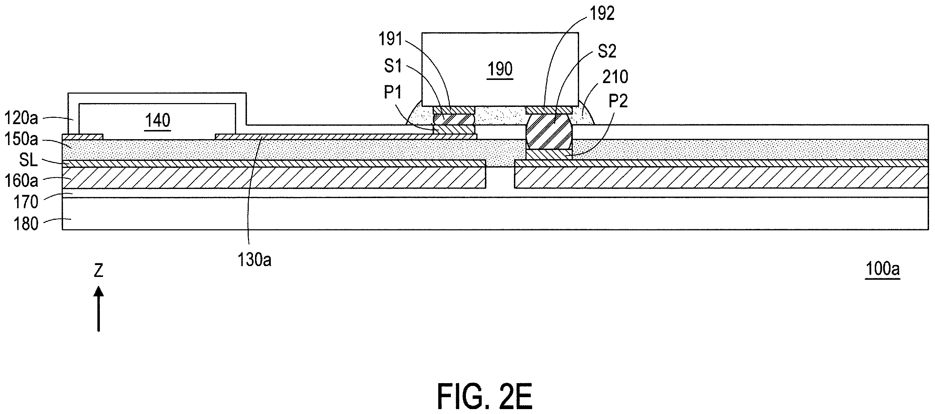

Then, please refer to FIG. 2E, the conductive pad P1 and the conductive pad P2 are respectively formed in the first opening O1 and the second opening O2a, the modulating unit 190 is provided, and the modulating unit 190 is disposed on the flexible substrate 180. In particular, the conductive pad P1 may be electrically connected to the metal layer 130a, and the conductive pad P2 may be electrically connected to the seed layer SL and the metal layer 160a. The modulating unit 190 may be disposed corresponding to the opening 161a of the metal layer 160a and the opening SL1 of the seed layer SL. For example, the modulating unit 190 may be overlapped with the opening 161a of the metal layer 160a and the opening SL1 of the seed layer SL in the normal direction (i.e., the direction Z) of the electronic device 100a. The modulating unit 190 may be connected to the conductive pad P1 and the conductive pad P2 via the solder pad S1 and the solder pad S2 respectively. The modulating unit 190 includes the first contact pad 191 and the second contact pad 192. The first contact pad 191 may be electrically connected to the driving unit 140 via the solder pad S1, the conductive pad P1, and the metal layer 130a, and the second contact pad 192 may be electrically connected to the metal layer 160a via the solder pad S2, the conductive pad P2, and the seed layer SL.

Next, referring further to FIG. 2E, the underfill 210 is formed between the modulating unit 190 and the protective layer 120a, so that the underfill 210 may cover and protect the solder pad S1, the solder pad S2, the first contact pad 191, and the second contact pad 192. In some embodiments, the electronic device 100a may also further be optionally molded. So far, the manufacture of the electronic device 100a of the present embodiment is substantially completed.

In the present embodiment, since the thickness T2 of the seed layer SL is less than 0.5 µm, the seed layer SL is not easily warped during a high-temperature process (for example, the process of manufacturing the driving unit 140), so the step of forming the seed layer SL may be before the step of disposing the driving unit 140.

Based on the above, it may be seen that the electronic device 100a of the present embodiment may include the flexible substrate 180, the adhesive layer 170, the metal layer 160a, the driving unit 140, and the modulating unit 190. In particular, the adhesive layer 170 is disposed on the flexible substrate 180. The metal layer 160a is disposed on the adhesive layer 170. The driving unit 140 is disposed on the adhesive layer 170. The modulating unit 190 is disposed on the adhesive layer 170.

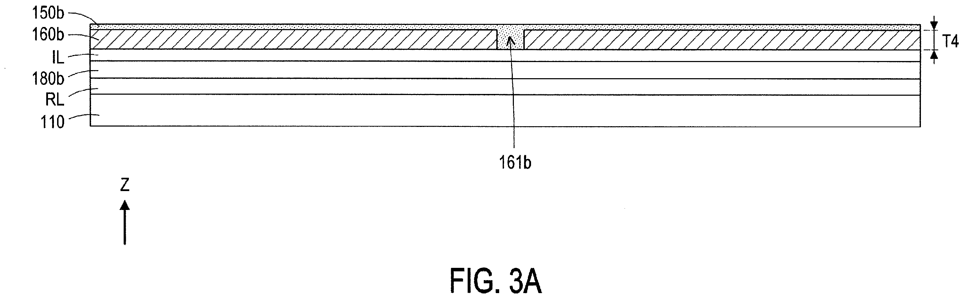

FIG. 3A to FIG. 3E are schematic cross-sectional views of a manufacturing method of an electronic device of the third of the disclosure. The embodiment shown in FIG. 3A to FIG. 3E is similar to the embodiment shown in FIG. 1A to FIG. 1D. Therefore, the same elements are denoted by the same reference numerals, and the details thereof are not repeated. In particular, an electronic device 100b of the present embodiment has flexible or curved characteristics, and the manufacturing method of the electronic device 100b of the present embodiment may include the following steps:

First, referring to FIG. 3A, the carrier substrate 110 is provided, the release layer RL is formed on the carrier substrate 110, the flexible substrate 180b is disposed on the carrier substrate 110, and the insulating layer IL is formed on the carrier substrate 110. In particular, the release layer RL is disposed between the flexible substrate 180b and the carrier substrate 110, and the release layer RL may be removed together with the carrier substrate 110 in a subsequent step. In some embodiments, the release layer may also not be provided between the flexible substrate and the carrier substrate according to requirements. In the present embodiment, the coefficient of thermal expansion of the flexible substrate 180b is substantially similar to the coefficient of thermal expansion of the carrier substrate 110, and the difference between the coefficient of thermal expansion of the flexible substrate 180b and the coefficient of thermal expansion of the carrier substrate 110 may be, for example, less than 5 ppm/°C, but the disclosure is not limited thereto. In the present embodiment, the insulating layer IL is disposed on the flexible substrate 180b, so that the flexible substrate 180b is located between the insulating layer IL and the release layer RL. The insulating layer IL may be a single-layer structure or a multi-layer structure, and may include, for example, an organic material, an inorganic material, or a combination thereof, but the disclosure is not limited thereto.

Next, please refer further to FIG. 3A, a metal layer 160b is formed on the carrier substrate 110, and an insulating layer 150b is formed on the carrier substrate 110. In particular, the metal layer 160b is disposed on the insulating layer IL. The metal layer 160b includes an opening 161b, and the opening 161b may expose a portion of the insulating layer IL. A thickness T4 of the metal layer 160b may be, for example, greater than 0.5 *µ*m, but the disclosure is not limited thereto. In particular, the thickness T4 is, for example, the thickness of the metal layer 160b measured along the normal direction of the carrier substrate 110 or the normal direction of the electronic device 100b (i.e., the direction Z). When the thickness T4 is greater than 0.5 *µ*m, the skin effect of a high-frequency signal may be reduced to reduce the loss of the signal. The insulating layer 150b is disposed on the metal layer 160b and inside the opening 161b of the metal layer 160b.

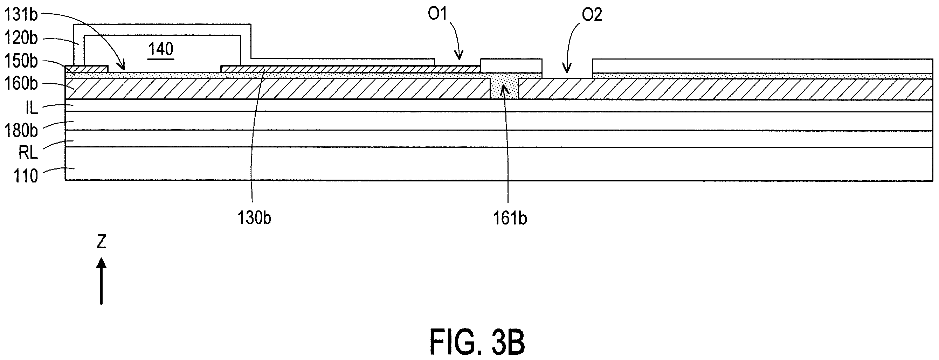

Next, please refer to FIG. 3B. A metal layer 130b is formed on the carrier substrate 110, the driving unit 140 is disposed on the carrier substrate 110, a protective layer 120b is formed on the carrier substrate 110, and the first opening O1 and the second opening O2 are formed. In particular, the metal layer 130b is disposed on the insulating layer 150b, and the metal layer 130b has an opening 131b that may expose a portion of the insulating layer 150. The driving unit 140 is disposed on the metal layer 130b and in the opening 131b of the metal layer 130b. The driving unit 140 may be electrically connected to the metal layer 130b, and the insulating layer 150b is located between the driving unit 140 and the metal layer 160b. The protective layer 120b is disposed on the driving unit 140, and the protective layer 120b may cover the driving unit 140, the metal layer 130b, and the insulating layer 150b. In the present embodiment, the protective layer 120b and the insulating layer 150b are drilled, for example, using laser drilling to form the first opening O1 and the second opening O2. In particular, the first opening O1 may expose the metal layer 130b, and the second opening O2 may expose the metal layer 160b. In some embodiments, the first opening O1 and/or the second opening O2 may be formed by etching process, but the disclosure is not limited thereto.

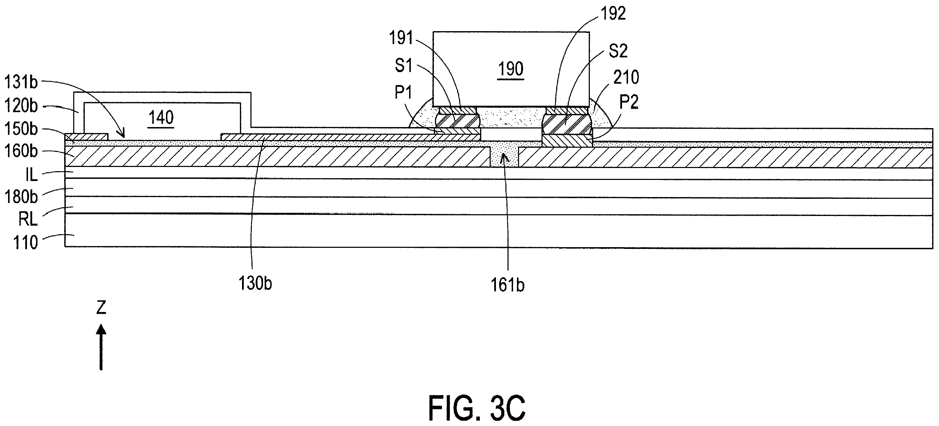

Then, please refer to FIG. 3C, the conductive pad P1 and the conductive pad P2 are respectively formed in the first opening O1 and the second opening O2, the modulating unit 190 is provided, and the modulating unit 190 is disposed on the flexible substrate 180b. In particular, the conductive pad P1 may be electrically connected to the metal layer 130b, and the conductive pad P2 may be electrically connected to the metal layer 160b. The modulating unit 190 may be disposed corresponding to the opening 161b of the metal layer 160b, and the modulating unit 190 may be overlapped with the opening 161b of the metal layer 160b in the normal direction (i.e., the direction Z) of the electronic device 100b. The modulating unit 190 may be connected to the conductive pad P1 and the conductive pad P2 via the solder pad S1 and the solder pad S2 respectively. The modulating unit 190 includes the first contact pad 191 and the second contact pad 192. The first contact pad 191 may be electrically connected to the driving unit 140 via the solder pad S1, the conductive pad P1, and the metal layer 130b, and the second contact pad 192 may be electrically connected to the metal layer 160b via the solder pad S2 and the conductive pad P2.

Next, referring further to FIG. 3C, the underfill 210 is formed between the modulating unit 190 and the protective layer 120b, so that the underfill 210 may cover and protect the solder pad S1, the solder pad S2, the first contact pad 191, and the second contact pad 192.

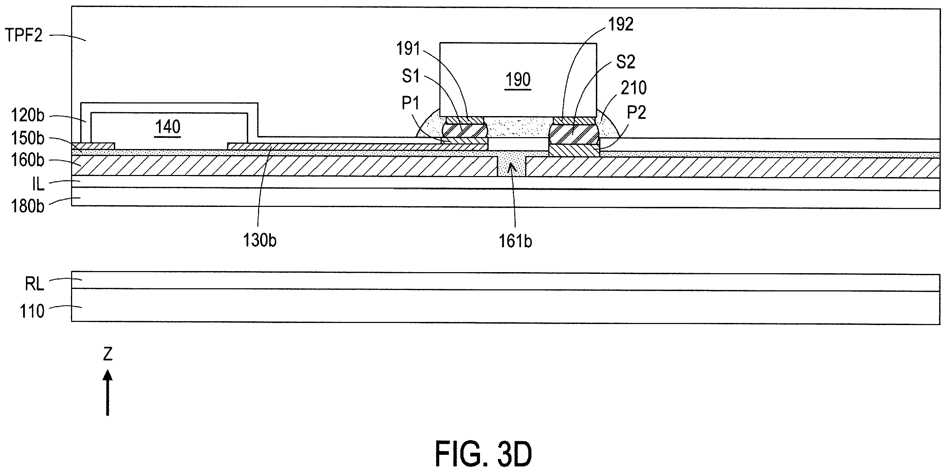

Then, referring to FIG. 3D, a temporary protective film TPF2 is formed on the carrier substrate 110, and the release layer RL and the carrier substrate 110 are removed to expose the flexible substrate 180b. In particular, the temporary film TPF2 is disposed on the protective layer 120b, so that the structure from which the release layer RL and the carrier substrate 110 are removed is not warped. In the present embodiment, the temporary protective film TPF2 is, for example, a base material containing a weak adhesive layer. For example, the material of the base material may include polyvinyl chloride, polyimide, or polyethylene terephthalate, but the disclosure is not limited thereto.

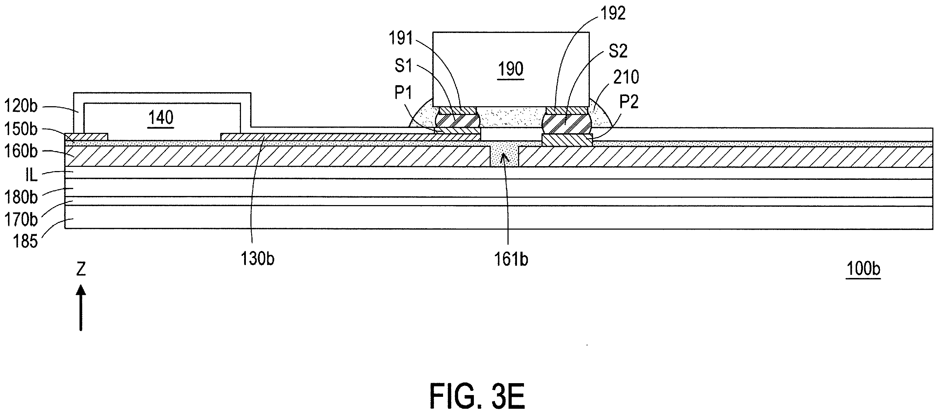

Next, referring to FIG. 3E, after the driving unit 140 is disposed, the adhesive layer 170b is formed on the temporary protective film TPF2, the flexible substrate 185 is provided, and the flexible substrate 185 and the temporary protective film TPF2 are combined. In particular, the adhesive layer 170b is disposed on the flexible substrate 180b, the flexible substrate 185 is disposed on the adhesive layer 170b, and the flexible substrate 185 may be combined to the flexible substrate 180b and the temporary protective film TPF2 via the adhesive layer 170b. In the present embodiment, since the flexible substrate 185 is combined to the flexible substrate 180b via the adhesive layer 170b after the driving unit 140 is disposed, the coefficient of thermal expansion of the flexible substrate 185 does not need to be particularly limited. In the present embodiment, by disposing another flexible substrate 185 on the flexible substrate 180b, the rigidity of the electronic device 100b may be increased, but the disclosure is not limited thereto. In some embodiments, the flexible substrate 185 may also not be provided according to requirements.

Next, please refer further to FIG. 3E, the temporary protective film TPF2 is removed to expose the protective layer 120b and the modulating unit 190. In some embodiments, the electronic device 100b may also further be optionally molded. So far, the manufacture of the electronic device 100b of the present embodiment is substantially completed.

In the present embodiment, since the coefficient of thermal expansion of the flexible substrate 180b is substantially similar to the coefficient of thermal expansion of the carrier substrate 110 (that is, the difference between the coefficient of thermal expansion of the flexible substrate 180b and the coefficient of thermal expansion of the carrier substrate 110 is less than 5ppm/°C), the step of disposing the flexible substrate can be performed before the step of disposing the driving unit and the manufacturing method of the present embodiment may still alleviate the issue of warpage during a high-temperature process (such as the process of manufacturing the driving unit 140).

Based on the above, it may be seen that the electronic device 100b of the present embodiment may include the flexible substrate 185, the adhesive layer 170, the metal layer 160b, the driving unit 140, and the modulating unit 190. In particular, the adhesive layer 170b is disposed on the flexible substrate 185. The metal layer 160b is disposed on the adhesive layer 170b. The driving unit 140 is disposed on the adhesive layer 170b. The modulating unit 190 is disposed on the adhesive layer 170b.

Based on the above, in the electronic device and the manufacturing method thereof of the disclosure, by using a flexible or bendable flexible substrate, the electronic device having the modulating unit of the present embodiment may be applied to a non-planar structure. Moreover, by performing the step of disposing the driving unit first, and then performing the steps of forming the insulating layer (or the protective layer), forming the metal layer, and disposing the flexible substrate, the issue of warpage may be alleviated. Moreover, via the method of making the coefficient of thermal expansion of the flexible substrate 180b substantially similar to the coefficient of thermal expansion of the carrier substrate 110 (that is, the difference between the coefficient of thermal expansion of the flexible substrate 180b and the coefficient of thermal expansion of the carrier substrate 110 is less than 5ppm/°C), the step of disposing the flexible substrate may be before the step of disposing the driving unit.

## Claims

1. An electronic device (100, 100a, 100b), comprising:
a flexible substrate (180, 180b, 185);
an adhesive layer (170) disposed on the flexible substrate (180, 180b, 185);
a first metal layer (160, 160a, 160b) disposed on the adhesive layer (170);
a driving unit (140) disposed on the adhesive layer (170); and
a modulating unit (190) disposed on the adhesive layer (170).

2. The electronic device (100, 100a, 100b) of claim 1, wherein a thickness (T1) of the first metal layer (160, 160a, 160b) is greater than 0.5 micrometers.

3. The electronic device (100, 100a, 100b) of claim 1, wherein the modulating unit (190) comprises a first contact pad (191) and a second contact pad (192), the first contact pad (191) is electrically connected to the driving unit (140), and the second contact pad (192) is electrically connected to the first metal layer (160, 160a, 160b).

4. The electronic device (100, 100a, 100b) of claim 1, wherein the first metal layer (160, 160a, 160b) comprises an opening (161, 161a, 161b), and the modulating unit (190) is disposed corresponding to the opening (161, 161a, 161b).

5. The electronic device (100, 100a, 100b) of claim 1, further comprising:
an insulating layer (150, 150a, 150b) disposed between the first metal layer (160, 160a, 160b) and the driving unit (140).

6. The electronic device of claim 1, wherein the modulating unit (190) is configured to modulate at least one of a phase, an amplitude, and a frequency.

7. The electronic device (100, 100a, 100b) of claim 1, further comprising:
a protective layer (120, 120a, 120b) disposed between the driving unit (140) and the modulating unit (190).

8. The electronic device (100, 100a, 100b) of claim 7, wherein the protective layer (120, 120a, 120b) comprises a first opening (O2, O2a) and a second opening (O1), the first opening (O2, O2a) exposes the first metal layer (160, 160a, 160b), and the second opening (O1) exposes a second metal layer (130, 130a, 130b).

9. A manufacturing method of an electronic device (100, 100a, 100b), comprising:
providing a carrier substrate (110);
forming a first metal layer (160, 160a, 160b) on the carrier substrate (110);
providing a flexible substrate (180, 180b, 185), and combining the flexible substrate (180, 180b, 185) and the carrier substrate (110);
removing the carrier substrate (110); and
providing a modulating unit (190), and disposing the modulating unit (190) on the flexible substrate (180, 180b, 185).

10. The manufacturing method of claim 9, further comprising:
disposing the driving unit (140) on the carrier substrate (110).

11. The manufacturing method of claim 10, wherein the modulating unit (190) comprises a first contact pad (191) and a second contact pad (192), the first contact pad (191) is electrically connected to the driving unit (140), and the second contact pad (192) is electrically connected to the first metal layer (160, 160a, 160b).

12. The manufacturing method of claim 10, further comprising:
forming an insulating layer (150, 150a, 150b) between the first metal layer (160, 160a, 160b) and the driving unit (140).

13. The manufacturing method of claim 10, further comprising:
forming a second metal layer (130, 130a, 130b) on the carrier substrate (110), so that the second metal layer (130, 130a, 130b) is electrically connected to the driving unit (140).

14. The manufacturing method of claim 13, further comprising:
forming a first opening (O2, O2a) to expose the first metal layer (160, 160a, 160b); and
forming a second opening (O1) to expose the second metal layer (130, 130a, 130b).

15. The manufacturing method of claim 9, further comprising: forming an adhesive layer (170) to combine the flexible substrate (180, 180b, 185) and the carrier substrate (110).
